# EUROPEAN PATENT APPLICATION

(11) **EP 1 341 300 A1**
(43) Date of publication of application: **03.09.2003**
(21) Application number: 02251368.3
(22) Date of filing: 27.02.2002
(51) Int. Cl.: H03F 1/02

(54) **Power amplifier with an adjustable quiescent current**

(71) Applicant: LUCENT TECHNOLOGIES INC., Murray Hill, New Jersey 07974-0636 (US)
(72) Inventor: Fischer, Georg, Nuremberg, Bvaria 90419 (DE); Ritter, Kai-Uwe, Roth, Bavaria 91154 (DE)
(74) Representative: Sarup, David Alexander

(57) **Abstract**

A transmitting apparatus, in particular for a mobile radio base station, is provided. The apparatus includes at least one power amplifier (10) which has at least one amplifier element (80) and one device (20, 90, 100) for forcing a quiescent current to flow into the amplifier element (80). The level of the quiescent current can be varied in dependance of the operating state of the transmitting apparatus.

## Description

### Technical Field

The invention relates to a transmitting apparatus, for example for a mobile radio base station according to the preamble of Claim 1, and to a power amplifier in particular for use in such a transmitting apparatus, according to the preamble of Claim 9.

### Background of the invention

Radio frequency power amplifiers which are required, for example, in mobile radio stations for the GSM mobile radio system are distinguished by a constant quiescent current, which ensures a mean power loss in the mobile radio station.

### Summary of the invention

The invention is now based on the object of providing a transmitting apparatus and a power amplifier, by means of which the mean power loss of a power amplifier can be reduced.

One fundamental idea of the invention is, for example, not to keep the quiescent current of the power amplifier constant during operation of a mobile radio base station, but to optimally match the level of the quiescent current to different operating states of the transmitting device.

The invention solves the object mentioned above, firstly, by the features of Claim 1.

According to this claim, a transmitting apparatus is provided which has at least one power amplifier. The power amplifier contains at least one amplifier element and means for forcing a quiescent current to flow into the amplifier element. The transmitting apparatus is distinguished in that the level of the quiescent current can be varied as a function of the operating state of the transmitting device.

Advantageous developments are the subject matter of the dependent claims.

It is known for phase modulators, in particular GMSK (Gaussian Minimum Shift Keying) modulators to be used for modulation of transmission signals in a mobile radio base station. These modulators ensure pure phase modulation of the transmission signal, that is to say the amplitude of the modulated signals is constant within a TDMA time slot. In other words, the modulated signal does not contain any amplitude modulation components. This situation can be used in an advantageous manner to build radio frequency power amplifiers with a very high efficiency, for example of about 50%. The radio frequency power transistors used in radio frequency power amplifiers generally have a linearity response which is dependent on the quiescent current. It is thus generally known that a low quiescent current results in poor linearity with high efficiency. On the other hand, a high quiescent current ensures that the radio frequency power transistor is highly linear, although its efficiency is poor. Power amplifiers with poor linearity, which is achieved with a low quiescent current of approximately 10% of the maximum current of the power amplifier, with the amplifier being operated in the so-called C-mode, can therefore be used for amplification of purely phase-modulated signals, which have a constant envelope. One advantageous feature of the C-mode, as already mentioned, is the high efficiency of the power amplifier. New modulation methods will now have to be introduced to satisfy future requirements for high data rates in mobile radio. One such modulation method is, for example, the 8-PSK modulation used in the EDGE Standard. Signals which have been modulated, for example, by means of 8-PSK modulation now also have amplitude-modulated components in addition to phase-modulated components. The amplitude-modulated components are subject to signal distortion if they are amplified using a non-linear power amplifier. Power amplifiers for amplifying signals which have both amplitude-modulated components and phase-modulated components must therefore be operated with a high quiescent current, for example of approximately 50% of the maximum current of the power amplifier, to ensure sufficient linearity of the power amplifier. Transmitting apparatuses with conventional power amplifiers which are operated with a constant quiescent current lead to an increased power loss when using different modulation methods, for example GMSK and 8-PSK modulation.

The power loss in the transmitting apparatus when using different modulation methods can now be reduced by providing controlling means which cause the quiescent current level to be set as a function of the modulation method which is applied to the signal to be amplified.

By way of example, as mentioned, the transmitting apparatus contains a pure phase modulator, such as a GMSK modulator and a phase and amplitude modulator, such as an 8-PSK modulator. Since, as explained, 8-PSK modulation demands a power amplifier with high linearity, a high quiescent current must be forced to flow into the amplifier element. However, a high quiescent current leads to poorer power-amplifier efficiency. For the situation where a GMSK modulated signal is produced by the transmitting apparatus, a low quiescent current is sufficient, as already mentioned, since such modulation methods operate reliably even with poor power amplifier linearity.

The power loss in the transmitting apparatus or the power amplifier can be reduced further by using the controlling means to set the quiescent current level to zero during a time in which there is no transmission, that is to say when no signal whatsoever is being transmitted. This avoids heat losses being produced unnecessarily.

The use of means for setting the quiescent current level of a power amplifier as a function of the operating state of the transmitting apparatus allows the power loss, and hence the complexity for its cooling, to be reduced considerably. In consequence, a number of transmitting and receiving modules can also be implemented in one base station.

For the situation of the transmitting apparatus operating using the time-division multiplex mode (TDMA mode), the controlling means can be implemented such that it cause the quiescent current level to be set on a time slot basis. If the quiescent current level is set or switched on a time slot basis, then it is expedient to reset the quiescent current between successive time slots, in particular in the so-called guard periods.

The quiescent current can be set or switched discontinuously by using hard switching, for example between three states, or else continuously by slowly increasing or reducing a control voltage by means of a digital/analogue converter.

The object mentioned above is likewise solved by the features of Claim 9.

According to this claim, a power amplifier has at least one amplifier element and means for forcing a quiescent current to flow into the amplifier element, in which case the level of the quiescent current can be varied as a function of the state of the signal to be amplified.

In this context, the expression the state of the signal to be amplified means not only the modulation method which is applied to the signal to be amplified, but also a state in which there is no signal.

Accordingly, one advantageous development provides controlling means which causes the quiescent current level to be set to zero during a time in which there is no transmission.

The controlling means can also set the quiescent current level as a function of the modulation method which is applied to the signal to be amplified.

The invention allows the power loss in the amplifier element, for example in an output stage power transistor, to be reduced, since an optimum quiescent current is always set for the type of modulation used in each particular case. In particular, higher output power levels can be produced during EDGE operation than for a GMS system.

### Brief Description of the Drawings

The invention will be explained in more detail in the following text with reference to an exemplary embodiment and in conjunction with the drawings, in which:
- Figure 1: shows a schematic block diagram of a radio frequency power amplifier according to the invention, for use in a mobile radio base station,
- Figure 2: shows the waveform of the output power of a signal which is modulated by means of a GMSK and 8-PSK modulator, and
- Figure 3: shows the waveform of the quiescent current for the power waveform shown in Figure 2.

### Detailed Description

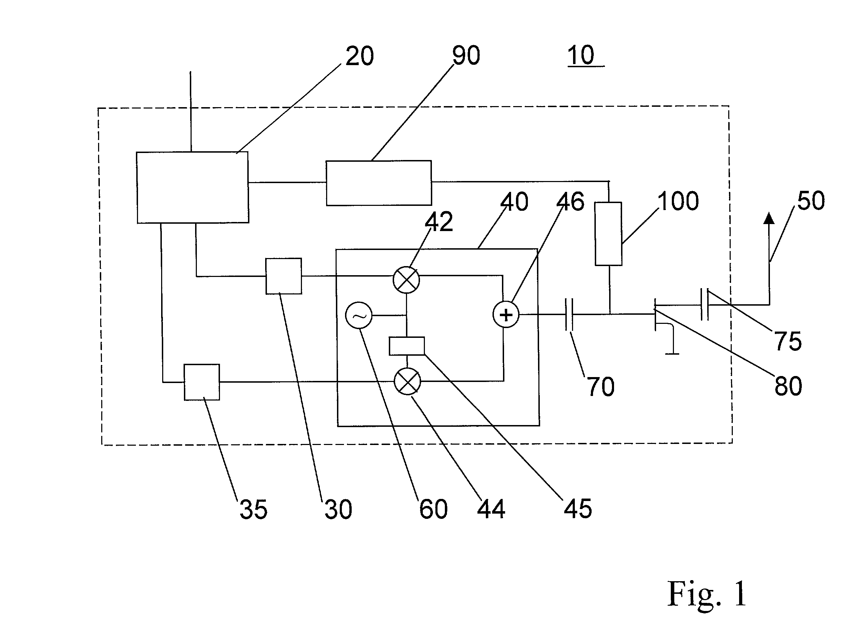

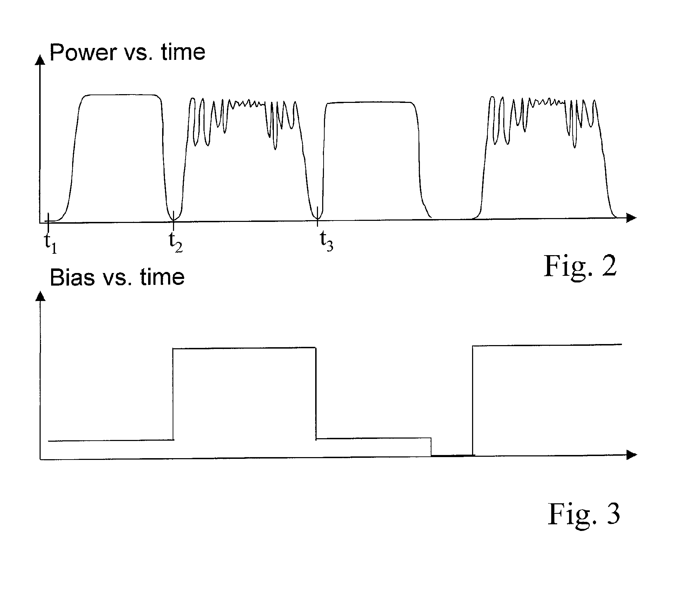

Figure 1 shows a radio frequency power amplifier 10, which can be used, for example, in a mobile radio base station in a GSM mobile radio system. On the input side, the radio frequency power amplifier 10 has a control circuit 20, for example in the form of a digital signal processor DSP. A modulated, digital, complex signal, for example, is applied to the input of the control circuit 20 and an example of its power waveform is shown in Figure 2. The I-component of this complex signal that appears at one output of the control circuit 20 is supplied via a D/A converter 30 to the first input of an IQ mixer 40, which is known per se and operates in analogue form, while, in contrast, the Q-component of the complex signal, which is produced at another output of the control circuit 20, is supplied via a D/A converter 35 to the second input of the IQ mixer 40. The IQ mixer 40 has two multiplexers 42 and 44, which are connected to an oscillator 60. In order to introduce a 90° phase shift between the I-component and the Q-component of the signal to be transmitted, the output signal from the oscillator 60 is passed via a 90° phase shifter 45 to one input of the multiplier 44. The output signal from the multipliers 42 and 44 is supplied to an adder 46. A coupling capacitor 70 provides DC isolation between the IQ mixer 40 and the radio frequency power transistor 80. The output signal from the radio frequency power transistor 80 is supplied via a coupling capacitor 75 to a transmitting antenna 50 of a mobile radio station. The radio frequency power transistor 80 may be, for example, an FET transistor.

Via a further output of the control circuit 20 a digital voltage value is converted via a D/A converter 90 to an analogue control voltage which, in conjunction with a resistor 100, results in a current flow, which flows as the quiescent current to the gate connection of the radio frequency power transistor 80.

The method of operation of the radio frequency power transistor 10 shown in Figure 1 will be explained in more detail in the following text.

In order to make it possible to comply with the future requirement for higher data rates in mobile radio, it is necessary to introduce new modulation methods. With regard to the GSM mobile radio system, a decision has in this case been made in favour of the EDGE Standard, which is based on 8-PSK modulation. EDGE systems are based on a time-division multiplex mode (TDMA mode), in which the data to be transmitted is transmitted in time slots. In order to make it possible to continue to operate, for example, mobile radio stations which are not EDGE compatible, it is provided that time slots which, for example, contain both GMSK modulated signals and 8-PSK modulated signals, can be located in mixed form on a carrier frequency. Figure 2 shows an example of the power waveform of one such signal. In detail, the first and third time slots show the envelope of a GMSK modulated signal while, in contrast, the second and fifth time slots show an 8-PSK-modulated signal. The fourth time slot indicates that no signal is transmitted at all.

In order to make it possible to reduce the power loss in a mobile radio base station when using, for example, two different modulation methods, as mentioned above, the radio frequency power amplifier 10 illustrated in Figure 1 is implemented such that the level of the quiescent current which is supplied via the resistor 100 to the power transistor 80 is set as a function of the modulation method being used at that time. Furthermore, the control device 20 is implemented such that no quiescent current is forced to flow into the gate connection of the radio frequency power transistor 80 when a time slot is found in which no signals are transmitted. The control circuit or the digital signal processor 20 is also able to identify pauses, or so-called guard periods, between successive time slots. Since the output power of the transmission signal is reduced during this time, it is possible to switch the quiescent current level in this time, since switching processes do not produce any interference spectral components in the output signal.

At the time t1, which is shown in Figure 2 and is located within a guard period, the control device 20 identifies the fact that the following time slot contains a GMSK-modulated signal. A voltage value is then transmitted from the control device 20 to the D/A converter 90, which converts this voltage value to an analogue control voltage, such that a small quiescent current is forced to flow via the resistor 100 into the radio frequency power amplifier 80. This is because, as already mentioned, GMSK signals do not contain any amplitude modulation components, so that it is permissible for the radio frequency power amplifier 80 to have poorer linearity without this producing unacceptable signal distortions. At the time t2, which is likewise shown in Figure 2 and once again occurs in a guard period, the control device 20 learns that an 8-PSK modulated signal will be transmitted in the subsequent second time slot. Since 8-PSK-modulated signals contain both phase-modulated components and amplitude modulation components, the radio frequency power amplifier 80 must have better linearity than a GMSK modulated signal. In consequence, the control device applies a higher voltage value to the D/A converter 90, which converts this to a corresponding analogue control voltage, such that a higher quiescent current is forced to flow via the resistor 100 into the radio frequency power transistor 80. At the time t3, the control device 20 learns that a GMSK-modulated signal will be transmitted once again in the next time slot. In consequence, in the manner already described, it causes a lower quiescent current to be supplied to the radio frequency power transistor 80.

At the time t4, which is illustrated in Figure 2, the control device 20 knows that no signal will be transmitted in the next time slot. In consequence, the control device 20 applies a digital voltage value of zero to the D/A converter 90, which ensures that no quiescent current flows into the radio frequency power amplifier 80. During this time period, no heat losses are produced in the radio frequency power amplifier 10 either.

Figure 3 shows the quiescent current flowing into the power transistor 80 whose level has been set as a function of the state of the transmission signal to be amplified, as shown in Figure 2, or as a function of the operating state of the transmitting apparatus in the mobile radio station.

## Claims

1. Transmitting apparatus, in particular for a mobile radio base station, having
at least one power amplifier (10) which has at least one amplifier element (80) and one device (20, 90, 100) for forcing a quiescent current to flow into the amplifier element (80),
**characterized in that**
the level of the quiescent current can be varied in dependance of the operating state of the transmitting apparatus.

2. Transmitting apparatus according to Claim 1,
**characterized by**
controlling means (20) which cause the quiescent current level to be set as a function of the modulation method which is applied to the signal to be amplified.

3. Transmitting apparatus according to Claim 1 or 2,
**characterized by**
a GMSK modulator and an 8-PSK modulator.

4. Transmitting apparatus according to Claim 1, 2 or 3,
**characterized by**
controlling means (20) which cause the quiescent current level to be set to zero during a time in which there is no transmission.

5. Transmitting apparatus according to Claim 4,
**characterized in that**
the transmitting apparatus operates in the time-division multiplex mode, and **in that**
said controlling means (20) cause the quiescent current level to be set on a time slot basis.

6. Transmitting apparatus according to Claim 5,
**characterized in that**
said controlling means (20) cause the quiescent current level to be set between successive time slots, in particular in the guard periods.

7. Transmitting apparatus according to one of Claims 3 to 6,
**characterized in that**
by amplifying an 8-PSK-modulated signal the adjusted quiescent current level which is set is higher than by amplifying a GMSK-modulated signal.

8. Transmitting apparatus according to one of Claims 1 to 7,
**characterized in that**
a new quiescent current level is set discontinuously or continuously.

9. Power amplifier, in particular for use in a transmitting apparatus according to one of Claims 1 to 8, having at least one amplifier element (80) and means (20, 90, 100) for forcing a quiescent current to flow into the amplifier element,
**characterized in that**
the level of the quiescent current can be varied as a function of the state of the signal to be amplified.

10. Power amplifier according to Claim 9,
**characterized by**
controlling means (20), which set the quiescent current level as a function of the modulation method which is applied to the signal to be amplified, and/or which cause the quiescent current level to be set to zero during a time in which there is no transmission.
